**Europäisches Patentamt**

**European Patent Office**

**Office européen des brevets**

(11) Publication number: **0 188 232**
**B1**

(12) **EUROPEAN PATENT SPECIFICATION**

(45) Date of publication of patent specification: **05.12.90**

(51) Int. Cl.⁵: **G 03 F 7/00, G 03 F 7/027**

(21) Application number: **86100235.0**

(22) Date of filing: **09.01.86**

(54) Radiation curable liquid resin composition.

(30) Priority: **10.01.85 JP 3070/85**

(43) Date of publication of application:
**23.07.86 Bulletin 86/30**

(45) Publication of the grant of the patent:
**05.12.90 Bulletin 90/49**

(84) Designated Contracting States:
**DE FR GB**

(56) References cited:
**EP-A-0 041 643**
**EP-A-0 092 783**
**EP-A-0 102 830**
**US-A-3 148 064**
**US-A-4 414 278**
**US-A-4 415 649**

The file contains technical information
submitted after the application was filed and
not included in this specification

(73) Proprietor: **Nippon Paint Co., Ltd.**
**2-1-2, Oyodokita Oyodo-ku**
**Osaka-shi Osaka-fu (JP)**

(72) Inventor: **Kanda, Kazunori**
**2-59-13 Asahigaoka**
**Yao-shi Osaka-fu (JP)**
Inventor: **Mizuguchi, Ryuzo**
**C-410,8 Yawatakitaura**
**Yawata-shi Kyoto-fu (JP)**

(74) Representative: **Kinzebach, Werner, Dr.**
**Patentanwälte Reitstötter, Kinzebach und**
**Partner Sternwartstrasse 4 Postfach 86 06 49**
**D-8000 München 86 (DE)**

## Description

The invention relates to a radiation curable liquid resin composition.

Liquid resin compositions which cure upon irradiation with high energy radiation have many important advantages. Since they may be cured within a few seconds without heating, they may be applied on thermally deformable substrates and do not require a large equipment upon curing. Since they are usually free from any volatile solvent and utilize electric energy for curing, they do not evolve harmful pollutants to the environment. When they are used as a photosensitive material, a high quality image may be reproduced by using short wavelength radiation. Consequently, they find a wide variety of uses in the coating, electronic, printing and other industry as UV or electron beam curable coating compositions, photoresists, electron beam resists, X-ray resists or printing plate making materials.

As is well-known, these radiation curable compositions are normally liquid prior to curing without using any volatile solvent in order that steps for removing solvent and setting the applied composition may be obviated. However, they have to possess a suitable viscosity level to impart them with desired workability without using such volatile solvent. This prevents prior art radiation curable compositions from being applied in a greater film thickness in a single coating operation. This is because the conventional compositions tend to run with the increase in the amount applied per unit area. The run property may be improved by the incorporation of fine silica particles or various body pigments. The addition of these inorganic fillers, however, tends to adversely affect the weather resistance, appearance or other physical properties of the resulting film. Besides, these inorganic particles tend to cause absorption or scattering of radiation applied because of the difference in refractive index, particle size distribution and chemical constitution between the inorganic particles and the matrix resin. This can result in uneven dose of high energy radiation which, in turn, may produce insufficiently cured portions or curing may take place in undesired areas.

EP—A—92783 discloses a photosensitive coating composition which essentially consists of (a) an ethylenically unsaturated compound having at least one terminal ethylenic group and being capable of forming a high polymer; (b) an organic, radiation-sensitive, free-radical-generating system which initiates polymerization of the unsaturated compound; (c) at least one organic polymeric binder; (d) discrete, substantially nonswellable cross-linked beads which are insoluble and nonagglomerating in a solvent for the organic polymeric binder component and in a solvent for the monomer or monomers used in the preparation of said beads; and (e) at least one solvent for components (a), (b) and (c). This coating composition can be dried quickly into the form of a film which is useful as a dry film photoresist.

EP—A—102830 discloses a coating composition which comprises (a) a monomer mixture of a compound having at least three acryloyloxy and/or methacryloyloxy groups in the molecule and of a compound having 1 to 2 α,β-ethylenically unsaturated bonds in the molecule, (b) at least one photo sensitizer and (c) an emulsion-type cross-linked polymer or copolymer. This coating composition has a delustering effect and gives moulded articles having a high abrasion resistance or scratch resistance.

EP—A—41643 relates to a thin photosensitive layer which upon lamination to the substrate is self-trimming at the edges thereof by the application of tensile stress to the layer transversely to the edge. The layer comprises (a) an addition polymerizable ethylenically unsaturated monomer, (b) an initiating system activated by actinic radiation and (c) a binder comprising a continuous major phase of an organic polymer compatible with (a) and (b) and a discontinuous minor phase of randomly dispersed nonfibrous solid particles.

US—A—3148064 discloses a photosensitive polymeric coating composition which comprises a solution of a lightsensitive film forming polymer in an organic solvent and finely divided translucent radiation transmitting pigment particles. The presence of the radiation transmitting pigment particles improves the speed, chemical and physical properties and adhesion to the support of coatings of such compositions.

It is, therefore, a principal object of the present invention to provide a radiation curable resin composition which can eliminate or ameliorate the above-discussed disadvantages of conventional compositions. Other objects and advantages of the present invention will become apparent to those skilled in the art as the description proceeds.

These and other objects and advantages of the present invention may be accomplished by providing a radiation curable resin composition comprising

(a) a radiation curable, liquid matrix resin, and

(b) 0.1 to 50% by weight, based on the total solids content of the resin composition, of polymer microparticles having a particle size from 0.01 to 0.6 μm of an internally cross-linked copolymer made of a mixture of ethylenically unsaturated monomers comprising a monomer having at least two polymerizable sites per molecule or a combination of two monomers having mutually reactive groups, said polymer microparticles being obtainable by emulsion polymerising said monomer mixture in an aqueous phase in the presence of an amphoionic group-containing, water soluble resin as an emulsifier.

Examples of high energy radiation include ultraviolet (UV) rays, electron beams, X-rays and other ionizing radiation. UV rays having a wavelength of 100—400 nm, preferably 200—300 nm (known as deep UV rays) may be used. These UV rays possess an energy level as high as 294.1—1260.5 kJ (70—300 kcal/mole) at which dissociation of molecules of ethylenically unsaturated organic compounds occurs.

Therefore, the UV light is capable of producing free radicals and thus initiating addition polymerization of the composition of this invention. Electron beams, X-rays and other ionizing radiation (including α-, β- and γ-rays and hard X-rays among which β-rays having suitable transmission properties may preferably be used as accelerated electron beams) are capable of producing ions, excited molecules and free radicals to initiate addition polymerization of the composition of this invention.

Preferably, the polymer microparticles are present in the final composition in amounts from 0.2 to 30% by weight based on the total solid content thereof.

The viscosity of the resulting radiation curable resin composition may be controlled to exhibit a yield value by the incorporation of polymer microparticles. In other words, the composition has a high apparent viscosity when stationary but the apparent viscosity decreases sharply when a shear force is exerted. This enables the composition of this invention to be applied in greater film thickness by a single coating operation without run due to the gravity flow, while retaining a proper workability.

The polymer microparticles have a chemical constitution and optical properties similar to those of the matrix resin and thus they do not adversely affect the transparency and the sensitivity to radiation of the composition of this invention. This avoids insufficient curing or curing of undesired areas from occurring and the appearance of finally cured film is not adversely affected.

The composition of this invention exhibits improved physical properties such as tensile strength, hardness, adhesion strength, flexural strength and abration resistance when compared with the corresponding composition free from the polymer microparticles. This may be explained by a physical interaction between the polymer microparticles and the matrix resin so that stresses are relaxed when applied externally.

The polymer microparticles can be obtained by emulsion polymerizing a mixture of ethylenically unsaturated monomers in an aqueous medium, and removing water from the emulsion for example by means of solvent substitution, azeotropic distillation, and centrifugation, drying. As emulsifier ampho-ionic group-containing, water-soluble resins as disclosed in Japanese Laid Open Patent Application No. 58-129066 are preferable. Ampho-ionic group-containing alkyd resins disclosed in U.S. Patent No. 4,322,324 and amphoteric amino sulfonate derivatives of epoxy resins disclosed in U.S. Patent No. 4,379,872 may advantageously be employed.

The starting monomer mixture contains, at least as a portion thereof, a monomer having at least two polymerizable sites per molecule or a combination of two monomers having mutually reactive groups to give microparticles which are internally cross-linked.

The polymeric microparticles have a diameter of 0.01 to 6 μm for retaining a good dispersibility, reactivity and stability in the cross-linkable polymer system.

Examples of ethylenically unsaturated comonomers used for the production of the microparticles include methyl (meth)acrylate, ethyl (meth)acrylate, n-butyl (meth)acrylate, isobutyl (meth)acrylate, 2-ethylhexyl (meth)acrylate, styrene, α-methylstyrene, vinyltoluene, t-butylstyrene, ethylene, propylene, vinyl acetate, vinyl propionate, acrylonitrile, methacrylonitrile and dimethylaminoethyl (meth) acrylate. Two or more comonomers may be combined.

Cross-linking comonomers include a monomer having at least two ethylenically unsaturated bonds per molecule and the combination of two different monomers having mutually reactive groups.

Monomers having at least two polymerization sites may typically be represented by esters of a polyhydric alcohol with an ethylenically unsaturated monocarboxylic acid, esters of an ethylenically unsaturated monoalcohol with a polycarboxylic acid and aromatic compounds having at least two vinyl substituents. Specific examples thereof include ethylene glycol diacrylate, ethylene glycol dimethacrylate, triethylene glycol dimethacrylate, tetraethylene glycol dimethacrylate, 1,3-butylene glycol dimethacrylate, trimethylolpropane triacrylate, trimethylolpropane trimethacrylate, 1,4-butanediol diacrylate, neopentyl glycol diacrylate, 1,6-hexanediol diacrylate, pentaerythritol diacrylate, pentaerythritol triacrylate, pentaerythritol tetracrylate, pentaerythritol dimethylacrylate, pentaerythritol trimethacrylate, pentaerythritol tetramethacrylate, glycerol diacrylate, glycerol allyloxy dimethacrylate, 1,1,1-tris(hydroxymethyl)ethane diacrylate, 1,1,1-tris(hydroxymethyl)ethane triacrylate, 1,1,1-tris(hydroxymethyl)ethane dimethacrylate, 1,1,1-tris(hydroxymethyl)ethane trimethylacrylate, 1,1,1-tris(hydroxymethyl)propane diacrylate, 1,1,1-tris(hydroxymethyl)propane triacrylate, 1,1,1-tris(hydroxymethyl)propane dimethacrylate, 1,1,1-tris(hydroxymethyl)propane trimethylacrylate, triallyl cyanurate, triallyl isocyanurate, triallyl trimellitate, diallyl phthalate, diallyl terephthalate and divinyl benzene.

Combinations to two monomers having mutually reactive groups may be used in place of, or in addition to monomers having two or more polymerization sites. For example, monomers having a glycidyl group such as glycidyl acrylate or methacrylate may be combined with carboxyl group-containing monomers such as acrylic, methacrylic or crotonic acid. Also, hydroxyl group-containing monomers such as 2-hydroxyethyl (meth)acrylate, 2-hydroxypropyl (meth)acrylate, hydroxybutyl (meth)acrylate, allyl alcohol or methallyl alcohol may be combined with isocyanato group-containing monomers such as vinyl isocyanate or isopropenyl isocyanate.

The polymer microparticles may be isolated by such conventional means as filtration, spray drying and lyophilization and used directly or after milling to a suitable particle size. Alternatively, the dispersion containing the microgel particles may be subjected to solvent substitution and the resulting dispersion in a new medium may be incorporated in the composition of this invention.

3

The particle size distribution of polymer microparticles may be regulated by the selection of polymerization method or by suitably mixing particles having different average particles sizes to achieve optimum rehology control of the composition containing the same. Furthermore, the physico-chemical properties of polymer microparticles such as glass transition temperature, solubility parameter, refractive index may be controlled as desired by suitably selecting their monomeric formulations. Polymer microparticles having on their surfaces functional or unsaturated groups capable of co-reacting with such groups possessed by other polymer microparticles or matrix resin may be incorporated to enhance the interaction between the polymer microparticles themselves or with the matrix resin. The polymer microparticles may also carry on their surfaces or interior a substance which promotes the radiation polymerization reaction such as photosensitizers or a substance which improves the properties of the cured composition such as stabilizers.

The proportion of polymer microparticles in the composition of the present invention preferably ranges from 0.2 to 30% by weight of the total solid content of the composition to achieve optimum rheology control and improved physical properties.

A variety of radiation curable liquid resins are known. The base liquid resin to be employed in the present invention may be selected from these known resins depending upon its intended ultimate use. For example, for use as a resist or plate making material, those capable of selectively removing unexposed areas from a base sheet with water, an alkali, an acid or an organic solvent are employed to leave images which have been exposed to high energy radiation.

Typical examples of high energy radiation curable resins are those referred to as photosensitive or photocurable resins. These resins consist of (a) film-forming polymers or oligomers capable (or incapable) of cross-linking through photochemical reactions, (b) photo-polymerizable monomers or low molecular weight oligomers, (c) photo-polymerization initiators or photosensitizers, and (d) heat-polymerization inhibitors or stabilizers. The resins may optionally contain further ingredients such as photosensitizer enhancers, colorants and other additives as desired.

Examples of film-forming polymers or oligomers include unsaturated polyester resins, urethane acrylate resins, epoxy acrylate resins, polyester acrylate resins, and spiran acrylate resins.

Examples of photo-polymerizable low molecular weight oligomers include low molecular weight oligomers of the above-named film-forming polymers or oligomers. Examples of photo-polymerizable monomers include styrene, vinyltoluene, divinylbenzene, vinyl acetate, (meth)acrylonitrile, esters of (meth)acrylic acid such as methyl (meth)acrylate, ethyl (meth)acrylate, butyl (meth)acrylate, 2-ethylhexyl (meth)acrylate, glycidyl (meth)acrylate, ethyleneglycol di-(meth)acrylate and trimethylolpropane tri-(meth)acrylate, diethyl itaconate, dibutyl itaconate, diethyl fumarate and diethyl maleate.

Examples of photosensitizers includes benzoin, benzoin methyl ether, benzoin propyl ether, benzoin butyl ether, benzophenone, diacetyl, benzil, dibutyl disulfide and dibenzyl disulfide.

Examples of heat-polymerization inhibitors include hydroquinone, t-butylhydroquinone, p-methoxyphenol, catechol, and benzoquinone.

Other radiation curable resins have similar compositions to the above-discussed photocurable resins except that they do not contain photosensitizers. Since these radiation curable resins are well-known in the art and do not constitute a part of the present invention, further explanation thereon will not be needed to those skilled in the art. The essential feature of the present invention resides in the use of polymer microparticles for controlling rheological properties of known and conventional radiation curable liquid base resins instead of using inorganic microparticles to thereby not only eliminate or ameliorate various disadvantages associated with such inorganic microparticles but also improve the physical properties of the cured products compared with the corresponding formulations free from such polymer microparticles.

The composition of this invention is therefore particularly useful in a number of its applications, for example, as plate making materials or inks used in the printing industry; as coating compositions, packaging materials or adhesives; as resists, dry films or sealants in processing electronic parts such as shadow masks, printed circuit boards, integrated circuits or LSI circuits; as photoresists used in other fields; as textile treating agents; as photocurable compositions for treating dental caries; and as enzyme immobilizing compositions.

The following examples are intended to illustrate the present invention in further detail. In these examples, all parts and percents are by weight unless otherwise indicated.

Example 1
Preparation of emulsifier

To a two liter flask having stirring means, a reflux condenser, temperature-control means, a nitrogen gas introducing tube and a decanter were added 134 parts of N,N-bis(hydroxyethyl)taurine, 130 parts of neopentyl glycol, 236 parts of azelaic acid, 186 parts of phthalic anhydride, and 27 parts of xylene. The mixture was refluxed and water was removed as an azeotropic mixture with xylene. The temperature was raised to 190°C over 2 hours and the reaction was continued with stirring until an acid number of 145 was reached.

The reaction product was cooled to 140°C and 314 parts of Cardura E-10 (glycidyl versatate, Shell Chemical Company) was added dropwise over 30 minutes at 140°C. The reaction was continued for additional two hours with stirring. A polyester resin having an acid number of 59, a hydroxyl number of 90 and a number average molecular weight ($\overline{Mn}$) of 1054 was obtained.

Example 2

Preparation of emulsifier

A flask used in Example 1 was charged with 73.5 parts of sodium taurinate, 100 parts of ethylene glycol, and 200 parts of ethylene glycol monomethyl ether. The temperature was raised to 120°C with stirring to give a uniform solution. To the solution was added with stirring a solution of 470 parts of Epikote 1001 (Shell Chemical Company, bisphenol A diglycidyl ether epoxy resin having an epoxy equivalent of 470) in 400 parts of ethylene glycol monomethyl ether over 2 hours. The mixture was stirred at the same temperature for additional 20 hours to complete the reaction. The reaction mixture was treated as in Example 1 above to give 518 parts of modified epoxy resin. The resin had an acid number of 49.4 (KOH titration) and a sulfur content of 2.8% (X-ray fluorometry).

Example 3

Preparation of polymer microparticles

To a one liter flask equipped with stirring means, cooling means and temperature-control means were added 380 parts of deionized water, 50 parts of the emulsifier resin prepared in Example 1 and 7 parts of dimethylethanolamine. The mixture was stirred at 80°C to make a solution. To the solution was added a solution of 2.5 parts of azobiscyanovaleric acid in 50 parts of water containing 1.6 parts of dimethylethanolamine. Then a monomer mixture consisting of 118 parts of styrene, 118 parts of ethyleneglycol dimethacrylate and 14 parts of 2-hydroxyethyl acrylate was added dropwise over 90 minutes. Stirring was continued for additional 90 minutes to give a polymer microparticle dispersion having a nonvolatile content of 43% and an average particles size of 45 nm. Polymer microparticles were obtained by lyophilizing the resulting polymer dispersion.

Example 4

Preparation of polymer microparticles

To a one liter flask equipped with stirring means, cooling means and temperature-control means were added 370 parts of deionized water, 40 parts of the emulsifier resin prepared in Example 2 and 3 parts of dimethylethanolamine. The mixture was stirred at 80°C to make a solution. To the solution was added a solution of 4.5 parts of azibiscyanovaleric acid in 45 parts of deionized water containing 4.3 parts of dimethylethanolamine. Then a monomer mixture consisting of 60 parts of styrene, 60 parts of methyl methacrylate, 90 parts of butyl acrylate, 5 parts of 2-hydroxyethyl acrylate and 25 parts of ethyleneglycol dimethacrylate was added dropwise over 60 minutes. After the addition of monomer mixture, a solution of 1.5 parts of azobiscyanovaleric acid in 15 parts of deionized water containing 1.4 parts of dimethylethanolamine was added. The mixture was stirred for additional 60 minutes at 80°C to give an aqueous dispersion of polymer microparticles having a nonvolatile content of 39% and a particle size of 50 nm.

Example 5

Preparation of polyester acrylate oligomer

A flask equipped with stirring means, cooling means and temperature-control means was charged with 134 parts of trimethylolpropane, 462 parts of hexahydrophthalic acid and 30.5 parts of toluene. The mixture was reacted at 150°C for 2 hours. Then 162 parts of butyl acetate and 2 parts of hydroquinone were added to the mixture. A mixture of 426 parts of glycidyl methacrylate, 1 part of hydroquinone, 5 parts of dibutyltindilaurate and 64 parts of butyl acetate was added dropwise over 5 hours while stirring at 110°C. The reaction was continued at the same temperature for additional 7 hours with stirring to give a resin solution having a solid content of 79% and an $\overline{Mn}$ of 1016. This product is hereafter referred to as "Resin Composition (A)".

Example 6

Preparation of photosensitive plate making resin composition

A laboratory kneader was charged with 500 parts of polyvinyl alcohol having a saponification degree of 80.7 mole % and an average M.W. of 500, and 680 parts of deionized water. The mixture was kneaded at 80°C to make a solution and then cooled to 60°C after the dissolution. Then a mixture of 1.2 parts of hydroquinone and 1673 parts of 2-hydroxyethyl methacrylate was added dropwise over 30 minutes with stirring. Then the mixture was further mixed with a solution of 50 parts of benzoin methyl ether in 215 parts of DMSO at 60°C for 15 minutes. The resulting product is hereinafter referred to as "Resin Composition (B)".

Example 7

High energy radiation curable liquid resin

A flask equipped with stirring means, cooling means and temperature-control means was charged with 800 parts of Epikote 1004 (bisphenol A diglycidyl ether epoxy resin sold by Shell Chemical), 200 parts of

# EP 0 188 232 B1

Versamid 230 (polyamide based hardener sold by General Mills), 280 parts of glycidyl methacrylate, 1100 parts of xylene and 1.2 parts of hydroquinone. The contents were thoroughly mixed and then allowed to stand at a temperature of 100—110°C. Then the mixture was allowed to cool to 60°C and xylene was removed under vacuum for 2 hours. To the resulting residue were added 150 parts of methyl methacrylate and 100 parts of butyl acrylate and the mixture stirred for additional 1 hour. The resulting product is hereinafter referred to as "Resin Composition (C)".

## Example 8

20 parts of polymer particles having an average particle size of 45 nm prepared in Example 3 were dispersed in 40 parts of isopropyl alcohol placed in a stainless steel beaker. To the beaker were introduced 253 parts of Resin Composition (A) prepared in Example 5 and 4 parts of benzoin methyl ether. Then the mixture was dispersed for 30 minutes by a laboratory disperser to give a photocurable resin composition.

The photocurable resin composition was applied on a clean glass plate to a dry film thickness of 200 µm using a doctor blade, allowed to stand for 2 hours at room temperature and then irradiated with UV light under the conditions set forth below. The resulting cured film was almost transparent and tack-free on finger testing.

A specimen for tensile testing was taken by stripping the film from the glass substrate and tested under the conditions set forth below. The specimen exhibited an initial Young's modulus of 245,2 N/mm$^2$ (25 kg/mm$^2$), an elongation of 41% and a breaking strength of 9.71 N/mm$^2$ (0.99 kg/mm$^2$). The maximum film thickness against run in vertical direction of this composition was 180 µm.

## Conditions for irradiating with UV light

A high pressure mercury lamp (Nippon Storage Battery Co., Ltd., Model HI-20N, 80 W/cm, equipped with a reflector beam collector) was placed over a conveyor at a height of 80 cm with the orientation of longitudinal axis of the lamp being perpendicular to the moving direction of the conveyor. The coated sample was passed under the lamp at a speed of 5 m/minutes.

## Conditions for tensile testing

Using Tensilon tester (Model HI-100, Toyo Baldwin Co., Ltd.), a test was made on a film having a length of 50 mm and width of 10 mm at a pulling rate of 50 mm/minutes.

## Comparative Example 1

The procedure of Example 8 was repeated except that 20 parts of polymer microparticles were replaced with 20 parts of calcium carbonate particles having an average particle size of 40 nm (TM Toyomaity, Toyo Denka Co., Ltd.). The resulting cured film was opaque and white and retained some tackiness upon finger testing.

## Comparative Example 2

The procedure of Example 8 was repeated except that the polymer microparticles dispersed in isopropyl alcohol were not incorporated. The resulting cured film exhibited an initial Young's modulus of 225.5 N/mm$^2$ (23 kg/mm$^2$), an elongation of 29% and a breaking strength of 8.14 N/mm$^2$ (0.83 kg/mm$^2$). The maximum film thickness against run in vertical direction was 90 µm.

## Example 9

135 parts of Resin Composition (B) prepared in Example 6 were mixed with 25.6 parts of polymer microparticles prepared in Example 4 in a kneader. The resulting mixture was degassed under vacuum to give a photocurable resin composition. This composition was heated to 60°C and extruded through a slit die on a tinplate substrate coated with a dispersion of red iron oxide pigment in a polyvinyl alcohol solution. The extrudate was covered by a rigid polyvinyl chloride sheet, pressed for 5 minutes under a pressure of 20,26 bar (20 kg/cm$^2$) and then dried at 60°C to give a photopolymer plate.

A negative film was placed on the photopolymer plate and the assembly was exposed to light from a mercury lamp for 3 minutes. The exposed plate was then developed by spraying tap water thereon. The resulting printing plate exhibited excellent image reproducibility, a sharp shoulder angle and convex cross-sectional configuration.

## Comparative Example 3

The procedure of Example 9 was repeated except that the dispersion of polymer microparticles was replaced with an aqueous dispersion of calcium carbonate (TM Toyomaity). The resulting printing plate exhibited poor image reproducibility and a bulged cross-sectional configuration. The reproduced image had a tendency of being expanded.

## Claims

1. A radiation curable composition comprising (a) a radiation curable, liquid matrix resin, and (b) 0.1 to 50% by weight, based on the total solids content of the resin composition, of polymer microparticles

6

having a particle size from 0.01 to 0.6 μm of an internally cross-linked copolymer made of a mixture of ethylenically unsaturated monomers comprising a monomer having at least two polymerizable sites per molecule or a combination of two monomers having mutually reactive groups, said polymer microparticles being obtainable by emulsion polymerising said monomer mixture in an aqueous phase in the presence of an amphoionic group-containing, water soluble resin as an emulsifier.

2. The radiation curable liquid resin composition of Claim 1, wherein said matrix resin is selected from the group consisting of unsaturated polyester resins, urethane acrylate resins, epoxy acrylate resins, polyester acrylate resins, spirane acrylate resins, and mixtures of an ethylenically unsaturated monomer with said resins.

3. The radiation curable liquid composition of Claim 1 or 2, wherein the amount of said microparticles is from 0.2 to 30% by weight based on the total solids content of said composition.

4. The radiation curable liquid resin composition of anyone of Claims 1—3, wherein said radiation is UV ray.

5. The radiation curable liquid resin composition of Claim 4, wherein said composition contains a photosensitizer.

6. The radiation curable liquid resin composition of anyone of Claims 1—3, wherein said radiation is electron beam radiation, X-ray or other ionizing radiation.

7. The radiation curable liquid resin composition of Claim 6, wherein said composition contains a heat polymerization inhibitor.

## Patentansprüche

1. Strahlungshärtbare Zusammensetzung, umfassend (a) ein strahlungshärtbares flüssiges Matrixharz und (b) 0.1 bis 50 Gew.-%, bezogen auf den Gesamtfeststoffgehalt der Harzzusammensetzung, Polymermikropartikel mit einer Partikelgröße von 0.01 bis 0.6 um eines intern vernetzten Copolymers, hergestellt aus einer Mischung aus ethylenisch ungesättigten Monomeren, umfassend ein Monomer mit wenigstens zwei polymerisierbaren Stellen pro Molekül oder eine Kombination aus zwei Monomeren mit gegenseitig reaktiven Gruppen, wobei die Polymermikropartikel durch Emulsionspolymerisierung der Monomermischung in einer wässrigen Phase in Anwesenheit eines amphoionische Gruppen enthaltenden, wasserlöslichen Harzes als Emulgator, erhältlich sind.

2. Strahlungshärtbare flüssige Harzzusammensetzung nach Anspruch 1, wobei das Matrixharz aus der Gruppe bestehend aus ungesättigten Polyesterharzen, Urethanacrylatharzen, Epoxyacrylatharzen, Polyesteracrylatharzen, Spiranacrylatharzen und Mischungen eines ethylenisch ungesättigten Monomers mit den Harzen, ausgewählt ist.

3. Strahlungshärtbare flüssige Harzzusammensetzung nach Anspruch 1 oder 2, worin die Menge der Mikropartikel 0.2 bis 30 Gew.-%, bezogen auf den Gesamtfeststoffgehalt der Zusammensetzung, ist.

4. Strahlungshärtbare flüssige Harzzusammensetzung nach einem der Ansprüche 1 bis 3, worin die Strahlung aus UV-Strahlen besteht.

5. Strahlungshärtbare flüssige Harzzusammensetzung nach Anspruch 4, worin die Zusammensetzung einen Photosensibilisator umfaßt.

6. Strahlungshärtbare flüssige Harzzusammensetzung nach einem der Ansprüche 1 bis 3 worin die Strahlung aus Elektronenstrahlen, Röntgenstrahlen oder anderen ionisierenden Strahlen besteht.

7. Strahlungshärtbare flüssige Harzzusammensetzung nach Anspruch 6, worin die Zusammensetzung einen Wärmepolymerisationsinhibitor aufweist.

## Revendications

1. Composition durcissable par les rayonnements, comprenant (a) une résine liquide servant de matrice, durcissable par les rayonnements, et (b) de 0,1 à 50% en poids, par rapport à la teneur totale en matières solides de la composition de résine, de microparticules de polymère ayant une taille de particules de 0,01 à 0,6 μm d'un copolymère à réticulation interne constitué d'un mélange de monomères à insaturation éthylénique comprenant un monomère ayant au moins deux sites polymérisables par molécule ou une association de deux monomères ayant des groupes mutuellement réactifs, ces microparticules de polymère pouvant être obtenues en polymérisant en émulsion ce mélange de monomères dans une phase aqueuse en présence d'une résine soluble dans l'eau contenant des groupes ampho-ioniques comme émulsionnant.

2. Composition de résine liquide durcissable par les rayonnements selon la revendication 1, dans laquelle cette résine de matrice est choisie parmi les résines polyester insaturées, les résines d'uréthane acrylate, les résines d'époxy acrylate, les résines de polyester acrylate, les résines de spirane-acrylate, et des mélanges d'un monomère à insaturation éthylénique avec ces résines.

3. Composition liquide durcissable par les rayonnements, selon les revendications 1 ou 2, dans laquelle la quantité de ces microparticules est de 0,2 à 30% en poids par rapport à la teneur totale en matières solides de cette composition.

4. Composition de résine liquide durcissable par les rayonnements selon l'une quelconque des revendications 1 à 3, dans laquelle ce rayonnement est un rayonnement U.V.

5. Composition de résine liquide durcissable par les rayonnements selon la revendication 4, dans laquelle cette composition contient un photosensibilisateur.

6. Composition de résine liquide durcissable par les rayonnements selon l'une quelconque des revendications 1 à 3, dans laquelle ce rayonnement est un rayonnement de faisceau électronique, un rayonnement X ou un autre rayonnement ionisant.

7. Composition de résine liquide durcissable par les rayonnements selon la revendication 6, dans laquelle cette composition contient un inhibiteur de la polymérisation thermique.